# DEMANDE DE BREVET EUROPEEN

(11) **EP 1 113 595 A1**
(43) Date de publication de la demande: **04.07.2001**
(21) Numéro de dépôt: 00403703.2
(22) Date de dépôt: 28.12.2000
(51) Int. Cl.: H04B 10/145, G02B 6/293, H01S 5/0687

(54) **Dispositif de comparaison de longueur d'onde et de multiplexage et système de réglage de sources monochromatiques**

(30) Priorité: 28.12.1999 FR 9916605
(71) Demandeur: ALCATEL, 75008 Paris (FR)
(72) Inventeur: Menezo, Sylvie, 94230 Cachan (FR)
(74) Mandataire: Ballot, Paul

(57) **Abrégé**

Dispositif de comparaison entre N longueurs d'onde nominales (λei) et les longueurs d'onde de signaux optiques couplés respectivement à des ports d'entrée (GEi) d'un phasar à réseau (R) de guides (Gj), ledit phasar comprenant un port de sortie principal (GS(m)) prévu pour collecter la combinaison desdits signaux, ledit port de sortie principal (GS(m)) étant placé en un point de focalisation correspondant à un ordre d'interférence déterminé m du réseau, caractérisé en ce que le phasar comprend deux ports de sortie secondaires de contrôle (A, B) respectivement situés au voisinage de points de focalisation correspondant aux ordres d'interférences m-1 et m+1 du réseau (R).

## Description

L'invention se rapporte à un dispositif de comparaison entre des longueurs d'onde nominales et des longueurs d'onde de signaux optiques couplés aux ports d'entrée d'un multiplexeur à réseau de guides, les signaux portés par les différentes longueurs d'onde se combinant sur un port de sortie du multiplexeur.

L'invention se rapporte également à un système de réglage de sources optiques monochromatiques, servant notamment à générer les ondes porteuses de ces signaux.

La comparaison est réalisée en vue du contrôle en longueur d'onde des sources optiques utilisées pour effectuer le multiplexage en longueur d'onde dans les réseaux de télécommunications. L'augmentation des besoins en densité des canaux de transmission des réseaux utilisant le multiplexage en longueur d'onde, accentue l'importance d'un contrôle rapide des longueurs d'onde des sources monochromatiques et de leur stabilité ; ces longueurs d'onde peuvent subir des dérives dues au vieillissement ou à des variations de température des sources monochromatiques pour lesquelles on utilisera généralement des lasers. On appelle longueur d'onde nominale, la longueur d'onde d'émission imposée au laser. Ces longueurs d'ondes nominales correspondent typiquement à des valeurs normalisées. On entend en général par port d'entrée (ou de sortie), un guide d'entrée (ou de sortie).

Parmi les différents types de multiplexeurs passifs connus, on va considérer dans la suite ceux qui utilisent un élément à dispersion angulaire tel qu'un réseau de diffraction gravé ou un réseau formé de guides d'onde, reliant deux coupleurs en étoile. Dans la suite, on désignera par phasar ce type de multiplexeur (désigné en anglais par <<Phased Arrayed Waveguide Grating Multiplexer>> ou <<AWG>>).

Un exemple de dispositif de contrôle en longueur d'onde des émetteurs optiques d'un phasar est proposé dans l'article << A wavelength matching scheme for multiwavelength optical links and networks using grating demultiplexers >> par F. Tong et al, IEEE Photonics Technology Letters, vol 7. No 6, June 1995. Dans la solution proposée, deux canaux de transmission sont dédiés à la comparaison des longueurs d'onde.

Dans l'article << Fabrication of multiwavelength simultaneous monitoring device using arrayed-waveguide grating >>, Electronics Letters, 14^{th} March 1996, Vol.32, N°6, les auteurs K. Okamoto et al, décrivent un dispositif nécessitant de prélever une partie des N signaux d'entrée pour les réintroduire dans le phasar et comparer en sortie les N signaux correspondants détectés de part et d'autre des N signaux de sortie principaux. Outre quelques pertes engendrées par le prélèvement d'une partie des N signaux d'entrée, cette solution nécessite de dupliquer les signaux d'entrée, opération fastidieuse à réaliser.

L'invention a pour but de proposer une solution ne présentant pas les inconvénients mentionnés précédemment.

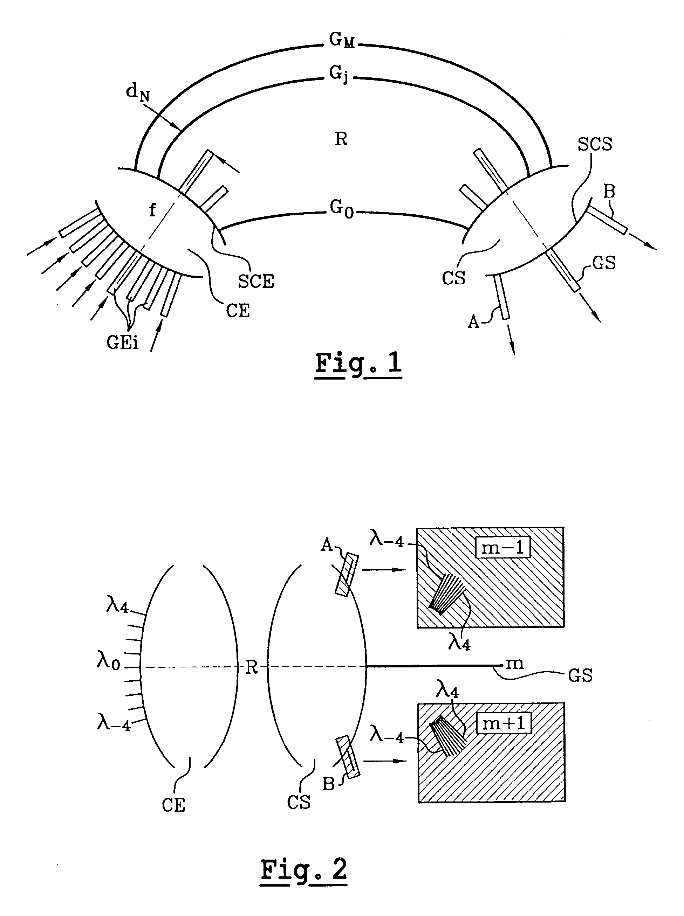

Une analyse détaillée du fonctionnement du type de phasar envisagé dans l'invention et représenté figure 1, montre que pour chaque longueur d'onde λi du laser d'émission i, i variant de 1 à N, l'onde optique constituant le signal d'entrée est couplée à un guide d'entrée GEi et subit les opérations suivantes :
- une diffraction dans un coupleur d'entrée CE, chaque guide Gj situé au niveau de la surface de sortie SCE du coupleur recevant une partie de l'onde diffractée,
- des déphasages dans un réseau R des M guides Gj, j variant de 0 à M, situé entre le coupleur CE et un coupleur CS, la longueur des guides Gj variant selon une fonction linéaire telle que LGj = LG0 + jΔL, ΔL étant la différence de longueur entre deux guides adjacents ; les déphasages produisant en sortie du réseau R de guides des interférences qui sont constructives dans une direction dépendant de la longueur d'onde,
- une focalisation sur la surface de sortie SCS du coupleur CS des interférences des ondes issues des guides du réseau R.

Le phasar selon l'invention est conçu pour que les ordres d'interférence adjacents m-1, m et m+1 correspondent à trois points de focalisation qui se forment sur la surface de sortie SCS du coupleur CS pour N longueurs d'onde déterminées, c'est-à-dire pour les N longueurs d'onde des lasers utilisés. Les signaux multiplexés résultant des interférences aux ordres m-1 et m+1 du réseau R sont utilisés pour le contrôle en longueur d'onde ; tandis que les signaux multiplexés résultant des interférences à l'ordre m possèdent le maximum de puissance et correspondent au signal utile.

Plus précisément, l'invention a pour objet un dispositif de comparaison entre N longueurs d'onde nominales λei et les longueurs d'onde de signaux optiques couplés respectivement à des ports d'entrée GEi d'un phasar à réseau R de guides Gj, ledit phasar comprenant un port de sortie principal GS(m) prévu pour collecter la combinaison desdits signaux, ledit port de sortie principal GS(m) étant placé en un point de focalisation correspondant à un ordre d'interférence déterminé m du réseau, principalement caractérisé en ce que le phasar comprend deux ports de sortie secondaires de contrôle (A, B) respectivement situés au voisinage de points de focalisation corrrespondant aux ordres d'interférence m-1 et m+1 du réseau R.

Ainsi, avec un dispositif unique on peut réaliser la fonction de multiplexage en longueurs d'onde et une fonction de contrôle des longueurs d'onde des sources d'émission des signaux à multiplexer. La solution proposée ne nécessite pas de duplication des signaux d'entrée. De plus, comme les points de focalisation pour les ordres m-1 et m+1 existent de toute façon dans las phasars usuels, elle n'entraîne aucune perte supplémentaire.

Concernant la réalisation pratique, un choix approprié des positions des ports de contrôle permet d'optimiser la fonction de contrôle. Pour cela, on utilise les fonctions de transmission TAi et TBi du phasar définies respectivement comme les rapports des puissances optiques présentes respectivement aux sorties A et B à la puissance optique du signal appliqué au port d'entrée GEi, ces rapports de puissance étant fonction de la longueur d'onde du signal appliqué.

Ainsi, selon une caractéristique de réalisation de l'invention, les positions des ports de sortie secondaires A et B sont ajustées pour que la différence entre les deux fonctions de transmission du phasar TAi et TBi pour les ports de sortie A et B, dénommée fonction de discrimination Di, soit nulle pour toutes les longueurs d'onde nominales λei et bijective en fonction de la longueur d'onde autour de la valeur nominale de la longueur d'onde la plus dispersée par le réseau aux ordres m-1 et m+1. Le caractère bijectif signifie qu'à chaque longueur d'onde prise autour de cette valeur nominale, correspond une seule valeur de la fonction de discrimination Di et réciproquement.

Les positions des ports de sortie secondaires A et B pourront être ajustées pour que, pour toutes les longueurs d'onde λei, l'écart spectral Δλei entre la longueur d'onde du maximum de la courbe de transmission TAi et la longueur d'onde de la courbe de transmission TBi, se trouve à la limite supérieure d'un écart spectral minimal Δλc déterminé expérimentalement. Cette condition assure le caractère bijectif de la fonction de discrimination Di.

Pour permettre un traitement électronique de la fonction Di, les deux ports de sortie secondaires sont couplés à des photodétecteurs.

L'invention concerne également un système de réglage de sources monochromatiques Li, caractérisé en ce qu'il comporte un dispositif de comparaison tel que décrit précédemment, dont des ports d'entrée GEi sont couplés respectivement aux dites sources, et des moyens d'asservissement CM pour ajuster la longueur d'onde d'au moins une desdites sources en fonction des signaux électriques fournis par lesdits photodétecteurs.

D'autres particularités et avantages de l'invention apparaîtront clairement à la lecture de la description faite à titre d'exemple non limitatif et en regard des dessins annexés sur lesquels :
- la figure 1 représente une vue schématique d'un phasar selon l'invention,
- la figure 2 montre plus en détail les points de focalisation des interférences aux ordres m-1, m et m+1 du réseau,
- la figure 3a) montre la correspondance entre les longueurs d'onde et les points de focalisation aux ordres m-1, m et m+1 et les ports de sortie A et B,
- la figure 3b) représente les courbes des fonctions de transmission TGSi, TAi, TBi en fonction de la longueur d'onde,
- la figure 3c) représente d'une part les courbes des fonctions de transmission TAi et TBi du phasar pour les guides A et B situés au voisinage des ordres m-1 et m+1, et d'autre part la courbe de la fonction de discrimination Di correspondante,
- la figure 4 représente l'étendue spectrale de contrôle en fonction de l'écart spectral introduit par le décalage géométrique des ports de sortie secondaires par rapport aux positions des points de focalisation pour les ordres m-1 et m+1,
- la figure 5 représente les fonctions de discrimination Di pour les longueurs d'onde d'émission des lasers considérés,
- la figure 6 représente un système de réglage de sources monochromatiques selon l'invention.

La figure 1 est une vue schématique d'un phasar. Il est constitué d'un premier coupleur CE en étoile dont l'entrée est reliée à une pluralité de guides d'entrée GEi. La surface de sortie SCE du coupleur CE qui se trouve face aux guides d'entrée GEi constitue une surface de réception d'ondes optiques d'entrée couplées aux guides GEi et dont on souhaite contrôler la longueur d'onde. La surface de sortie SCE est reliée à un réseau R de M guides Gj. L'autre extrémité du réseau R est reliée à un coupleur en étoile CS. La surface de sortie SCS du coupleur CS qui se trouve face au réseau R constitue une surface de réception des ondes issues de R et est reliée à 3 guides A, GS et B. Le guide GS est affecté à l'ordre d'interférence m du réseau R, les guides A et B étant respectivement situés au voisinage des points de focalisation pour les ordres m-1 et m+1 du réseau R.

Le détail des points de focalisation des interférences aux ordres m-1 et m+1 est présenté sur la figure 2. Pour chacun de ces deux ordres, la localisation des points de focalisation varie en fonction de la longueur d'onde λi (par exemple λ-4, ...λ0, ..., λ+4) de chaque signal d'entrée : elles ne sont pas localisées en un même point comme c'est le cas pour l'ordre m. Le point de focalisation le plus décalé géométriquement par rapport à la position centrale pour l'ordre considéré correspond à la longueur d'onde la plus dispersée dont un exemple est donné sur la figure 2 sous la référence λ-4.

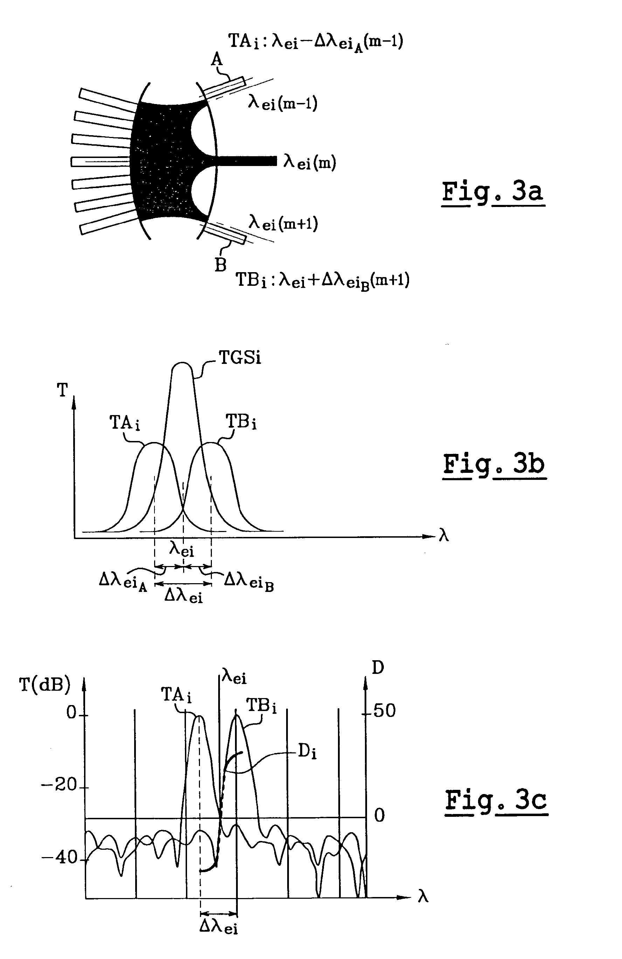

Selon l'invention et comme indiqué figure 3a), on ajoute deux guides de sortie de contrôle A et B au voisinage des points de focalisation pour les ordres m-1 et m+1 ; A et B désignent indifféremment les ports de sortie secondaires ou les guides placés au niveau de ces ports. Sur cette figure sont également indiquées les longueurs d'onde des signaux multiplexés résultant des interférences respectivement formées aux ordres m-1, m et m+1 ainsi qu'au centre des ports A et B. Le décentrage des guides A et B par rapport aux positions exactes des points de focalisation pour les ordres m-1 et m+1 est cependant suffisamment petit par rapport à la région de couplage de ces guides pour que ceux-ci puissent collecter chacune des longueurs d'onde de l'ensemble des signaux multiplexés ( correspondant aux N longueurs d'onde des lasers utilisés ). Au décalage géométrique de chacun des guides A et B correspond un décalage spectral noté Δλei. On dénomme ΔλeiA, l'écart spectral entre la longueur d'onde nominale λei et la longueur d'onde du maximum de la courbe de transmission TAi en A. De même pour ΔλeiB. Les guides A et B sont positionnés pour que ΔλeiA = ΔλeiB. On pose Δλei = ΔλeiA + ΔλeiB.

La fonction de transmission T de ce phasar, entre un guide d'entrée et un guide de sortie, aussi appelée fonction de transfert dans la littérature, s'exprime en fonction de la longueur d'onde par une fonction de type gaussien. Sur la figure 3b) sont représentées la fonction de transmission TGSi pour GS ainsi que les fonctions de transmission TAi et TBi pour A et B. Le positionnement des guides A et B par rapport aux points de focalisation pour les ordres m-1 et m+1 est ajusté pour que, lorsqu'on analyse sur un même dispositif les fonctions de transmission TAi en A et TBi en B, le point de croisement des courbes représentatives de TAi et TBi coïncide avec la longueur d'onde nominale λei. Lorsque la longueur d'onde émise par le laser λi à l'entrée du guide GEi est identique à la longueur d'onde nominale λei, la différence entre les deux fonctions TAi et TBi s'annule. Cette différence est appelée fonction de discrimination Di et s'exprime en fonction de la longueur d'onde. Lorsque la longueur d'onde d'émission s'écarte de la longueur d'onde nominale λei, la fonction de discrimination Di prend une valeur non nulle, positive si elle est supérieure à la longueur d'onde nominale λei, négative si elle est inférieure. On pourra alors déduire la dérive en longueur d'onde du laser d'émission correspondant par rapport à la longueur d'onde nominale désirée.

Sur la figure 3c) sont représentées les fonctions de transmission TAi et TBi au niveau des guides A et B situés au voisinage des points de focalisation pour les ordres m-1 et m+1 ainsi que la courbe de la fonction de discrimination Di.

On désignera par étendue spectrale de contrôle, la plage de longueur d'onde pour laquelle la fonction de discrimination Di est bijective. Lorsque la fonction de discrimination Di n'est plus bijective, le contrôle en longueur d'onde du laser d'émission n'est plus réalisable.

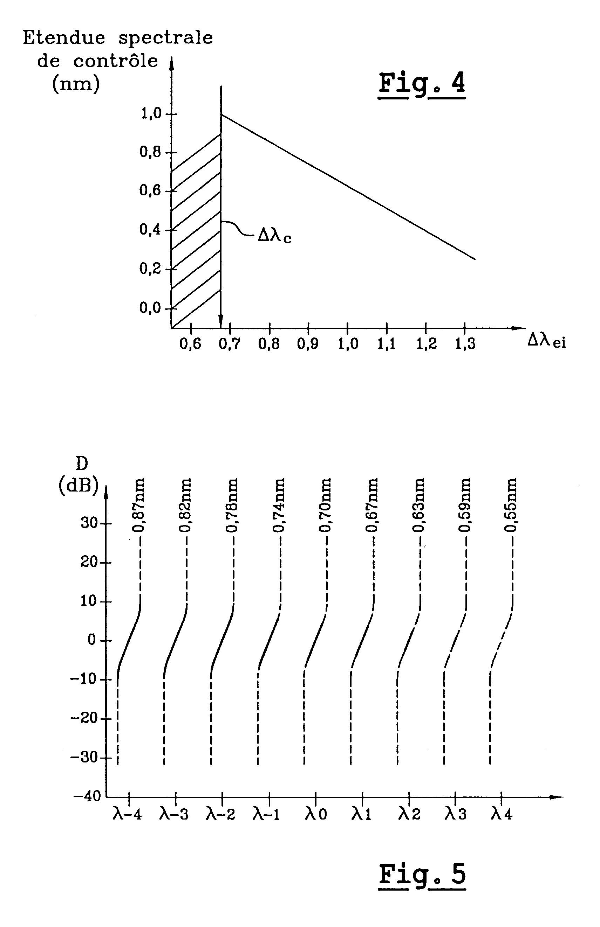

La figure 4 représente l'étendue spectrale de contrôle, en fonction de l'écart spectral Δλei introduit par le décentrage géométrique des ports de sortie secondaires A et B. Une zone hachurée est indiquée sur cette figure pour laquelle, lorsque l'écart Δλei < Δλc, la fonction de discrimination Di n'est plus bijective. La position des guides A et B est optimisée pour que l'étendue spectrale de contrôle soit la plus grande et se trouve ainsi à la limite supérieure de cette zone. Pour que la relation Δλei > Δλc soit valable pour toutes les longueurs d'onde λei, il suffit qu'elle soit vérifiée pour la longueur d'onde la plus dispersée, λ-4.

La figure 5 représente les fonctions de discrimination D pour les longueurs d'onde considérées. On remarque que l'étendue spectrale de contrôle (indiquée au dessus de chaque courbe) est différente pour chaque longueur d'onde d'émission des lasers en raison de la dispersion chromatique introduite par le dispositif.

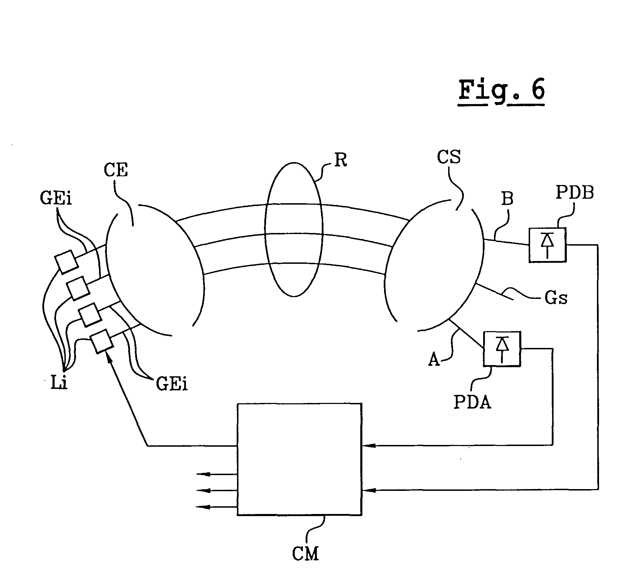

Afin de corriger les longueurs d'onde des sources monochromatiques en fonction des écarts révélés par les comparaisons, on réalise un système de réglage tel que représenté à la figure 6.

Les sources Li couplées aux ports d'entrée Gei peuvent être des lasers modulés par commande directe de leur courant d'alimentation ou des lasers à émission continue associés à des modulateurs électro-optiques.

Des photodétecteurs PDA et PDB sont couplés respectivement aux ports de sortie secondaires A et B. Des moyens électroniques d'asservissement CM ont des entrées reliées aux photodétecteurs PDA, PDB et des sorties de commande des longueurs d'onde des sources Li. Ces commandes agissent par exemple sur la température ou le courant d'alimentation de la source à régler.

La façon la plus simple pour effectuer le réglage consiste à arrêter le fonctionnement de toutes les sources, sauf celle à régler, puis à ajuster le paramètre de réglage de la source de façon à annuler la fonction D correspondant à la longueur d'onde nominale attribuée à la source. Ces opérations sont effectuées après un calibrage préalable du phasar à l'aide d'une source de référence dont la longueur d'onde est connue avec précision (par exemple la raie de C2H2).

Il est possible aussi de régler une des sources sans arrêter le fonctionnement des autres sources. Pour cela, on applique à la source à régler une modulation de fréquence déterminée qui permet à l'asservissement CM de déterminer par filtrage électronique la puissance de la source à régler.

Les résultats indiqués sur les figures précédentes ont été obtenus pour un phasar dont les paramètres sont reportés dans les tableaux suivants :

| Paramètres des guides d'onde et des coupleurs | Valeur |
|---|---|
| Indice effectif des guides GEi, GS, A, B et Gj | 3.1993 |
| Indice effectif dans les coupleurs CE et CS | 3.2139 |
| Largeur de la taille du mode guidé | 0.86 µm |
| Dispersion chromatique du coupleur CS | -0.288 1/µm |
| Dispersion chromatique du réseau R | -0.306 1/µm |

| Paramètres géométriques | Valeur |
|---|---|
| Distance entre les guides GEi (ou GS et A et GS et B) au niveau du coupleur CE ( ou CS) | 6 µm |
| Distance dN entre 2 guides Gj adjacents | 3 µm |
| Focale f des coupleurs CE et CS | 338.809 µm |
| ΔL entre 2 guides Gj adjacents | 44.8242 µm |
| Ordre d'interférence m | 93 |
| Nombre N de guides Gj du réseau R | 60 |

Les longueurs d'onde du peigne d'émission considéré λ-4 , ..., λ0, ..., λ4 sont en nm :

| λ-4 | λ-3 | λ-2 | λ-1 | λ0 | λ1 | λ2 | λ3 | λ4 |
|---|---|---|---|---|---|---|---|---|
| 1548.4 | 1546.8 | 1545.2 | 1543.6 | 1542.0 | 1540.4 | 1538.8 | 1537.2 | 1535.6 |

## Revendications

1. Dispositif de comparaison entre N longueurs d'onde nominales (λei) et les longueurs d'onde de signaux optiques couplés respectivement à des ports d'entrée (GEi) d'un phasar à réseau (R) de guides (Gj), ledit phasar comprenant un port de sortie principal (GS(m)) prévu pour collecter la combinaison desdits signaux, ledit port de sortie principal (GS(m)) étant placé en un point de focalisation correspondant à un ordre d'interférence déterminé m du réseau, caractérisé en ce que le phasar comprend deux ports de sortie secondaires de contrôle (A, B) respectivement situés au voisinage de points de focalisation correspondant aux ordres d'interférences m-1 et m+1 du réseau (R).

2. Dispositif selon la revendication 1, caractérisé en ce que les positions des ports de sortie secondaires (A, B) sont ajustées pour que la différence entre les deux fonctions de transmission du phasar (TAi, TBi) pour les ports de sortie (A, B), dénommée fonction de discrimination (Di), soit nulle pour toutes les longueurs d'onde nominales (λei) et bijective en fonction de la longueur d'onde autour de la valeur nominale de la longueur d'onde la plus dispersée par le réseau (R) aux ordres m-1 et m+1.

3. Dispositif selon la revendication 2, caractérisé en ce que les positions des ports de sortie secondaires (A, B) sont ajustées pour que, pour toutes les longueurs d'onde nominales (λei), l'écart (Δλei) entre la longueur d'onde du maximum de la courbe de transmission (TAi) et la longueur d'onde du maximum de la courbe de transmission (TBi) se trouve à la limite supérieure d'un écart minimal (Δλc).

4. Dispositif selon l'une des revendications 1 à 3, caractérisé en ce qu'il comporte des photodétecteurs (PDA, PDB) couplés respectivement aux deux ports de sortie secondaires (A, B).

5. Système de réglage de sources monochromatiques (Li), caractérisé en ce qu'il comporte un dispositif de comparaison selon la revendication 4, dont des ports d'entrée (GEi) sont couplés respectivement auxdites sources, et des moyens d'asservissement (CM) pour ajuster la longueur d'onde d'au moins une desdites sources en fonction des signaux électriques fournis par lesdits photodétecteurs.
